Europäisches Patentamt

European Patent Office

Office européen des brevets

(19)

(11) Publication number: **0 127 946**
**A1**

(12) **EUROPEAN PATENT APPLICATION**

(21) Application number: **84302964.6**

(22) Date of filing: **02.05.84**

(51) Int. Cl.³: **H 01 L 21/90**
**H 01 L 23/52**

(30) Priority: **10.05.83 GB 8312850**

(43) Date of publication of application:
**12.12.84 Bulletin 84/50**

(84) Designated Contracting States:
**AT BE CH DE FR GB IT LI LU NL SE**

(71) Applicant: **BRITISH TELECOMMUNICATIONS**
**2-12 Gresham Street**
**London EC2V 7AG(GB)**

(72) Inventor: **Heslop, Christopher John**
**7 Viking Heights**
**Martlesham Woodridge Suffolk(GB)**

(72) Inventor: **Wright, Steven John**
**"Serendipity" Red House Farm Lane**
**Bawdsey Woodbridge Suffolk(GB)**

(72) Inventor: **Hines, Robert Edgar**
**3 Coniston Close**
**Felixtowe Suffolk(GB)**

(74) Representative: **Purell, Kevin John et al,**
**British Telecom Intellectual Property Unit 13th Floor 151**
**Gower Street**
**London WC1E 6BA(GB)**

(54) **Method of producing a via in a semiconductor device.**

(57) A method of producing a via in the fabrication of a semiconductor wafer is disclosed. Vias are used in semiconductor wafer fabrication as a means of providing electrical connexions between different layers of the wafer.

The walls of known vias are difficult to coat reliably with metal because, particularly in the case of fabrication processes aimed at small line widths, the vias must be kept within certain size limits and necessarily have vertical walls.

The method described involves the formation in a layer of dielectric material (8) of two communicating passageways. One passageway (11) has sloping walls (12) to facilitate metal coating. The other passageway (13) has substantially vertical walls (14), thus keeping the via within required dimensions at the region of the wafer to which a connexion is to be made. The two passageways (11, 13) are produced in separate process steps, a non-erodable layer (9) being used to define the via.

Fig.2

0127946

## SEMICONDUCTOR WAFER FABRICATION

This invention relates to a method of producing a via, in the fabrication of a semiconductor wafer.

"Vias" are known in semiconductor wafer fabrication as a means for providing electrical connexions between different layers of the wafer. For example, a connexion can be provided by a via between an "interconnect" (a metal path for connecting devices formed in the wafer) at a lower level in the wafer and an interconnect at a higher level in the wafer. Such a via is an opening provided in a dielectric material separating the two levels. This opening is subjected to a metallisation step (for example, the vacuum evaporation of aluminium) in the fabrication process so that - along with the formation of the interconnect at the higher level - the sides of the opening are coated with metal, thus providing a conductive path between the two interconnects. As such, vias are somewhat akin to the so-called "plated-through holes" used for printed circuit boards. By permitting the interconnexion of devices and the like at different levels in a wafer, vias provide a means of packing more devices per unit area of wafer.

The dielectric material used to separate the two layers is commonly a film of polyimide. This film is made by coating the surface of the wafer with a solution of polyamic acid and spreading this solution over the surface by spinning the wafer, at, say, 10,000 r.p.m. This so-called "spin coating" stage is followed by drying and curing stages to yield the polyimide film.

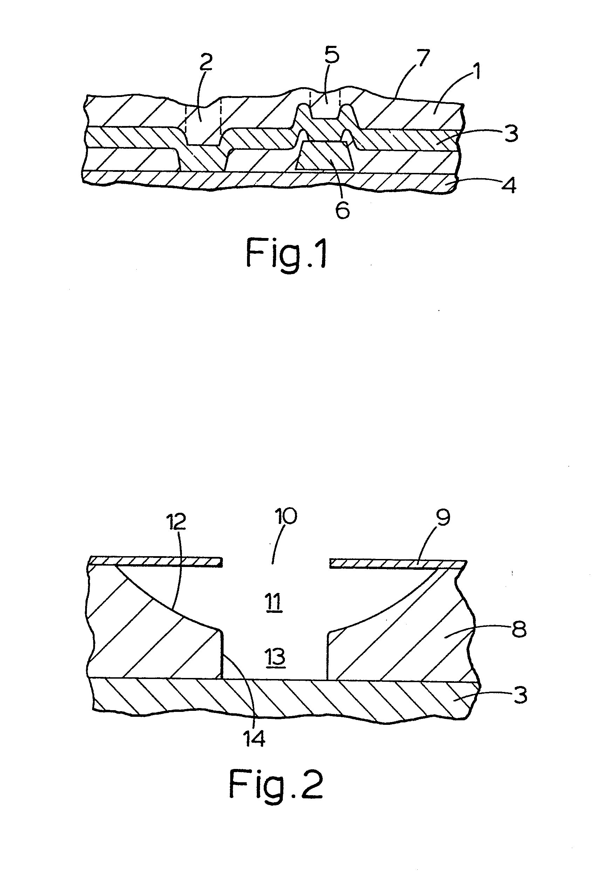

The spin coating stage described above tends to produce levelling of the surface of the polyimide film formed, rather than permitting this film to follow strictly the contours of the underlying layers of the wafer. Thus, referring to Figure 1 of the accompanying drawings - which shows a cross-section of a portion of semiconductor wafer after the spin coating stage in the fabrication process - the thickness of polyimide film 1 which needs to be removed to create an opening for a via depends on the underlying circuit features. Typically, the thickest region of polyimide film 1 is a region 2 delineated by broken lines in Figure 1 and overlying a point at which a layer of metal interconnect 3 has been deposited to provide a connexion with the wafer substrate 4; this region 2 may have a thickness of 1.5µm. The thinnest region of polyimide film 1 (which may have a thickness of, for example, 1µm) is typically a region 5 overlying a point at which the layer of metal interconnect 3 provides a connexion with a polysilicon gate 6.

After removal by etching of the polyimide film 1 to form openings for vias in the regions 2 and 5, surface 7 of the polyimide film 1 is subjected to a metallisation step which is intended also to cause the walls of these openings to be coated with metal to provide conductive paths to the metal interconnect 3. Unfortunately, the variation in the thickness of dielectric which must be removed to create a via creates difficulties. This is because the degree of etching required to form an opening for a via at the thickest point (region 2) in the polyimide film 1 will cause the formation - at the thinnest point (region 5) - of an opening for a via which exceeds the desired maximum size for the horizontal (with respect to the wafer) dimension of the via.

This problem is particularly apparent with fabrication processes aimed at relatively small line widths. For example, in the case of a 3 micron CMOS fabrication process, the maximum allowable size for vias is typically 3.5µm, and this is exceeded at the thinnest points (say 1µm) in the polyimide film 1 by the spreading of the horizontal dimension of the via opening due to the formation of sloping via walls by so-called "over-etching" of the polyimide film 1 as a result of a standard wet etching step with a simple resist mask. Such wet etching is known as isotropic etching because the chemical etchant acts equally in all directions, thus undercutting the layer of resist to produce the above-mentioned deviation from the required dimensions.

The ratio of vertical to lateral etching rate may vary between 1 (the isotropic etching described above) and infinity (known as purely anisotropic etching).

It is possible to keep within the desired size limits for vias at different points in the polyimide film 1 by employing an anisotropic etching step with a non-erodable mask. This etching gives via openings having vertical (with respect to the wafer) walls, thus keeping within the desired dimensions. Unfortunately, these vertical walls are difficult to coat with metal to the required degree of reliability during the subsequent metallisation step.

European Patent Application No. 82103175.4 (Publication No. 66 069) discloses a method of making vias in two stages. In a first stage, accurate via openings are plasma etched in a thin layer of silicon nitride. This is followed by the deposition of a thicker layer of polyimide and forming larger, corresponding openings in this layer. Although this method produces vias of a size permitting reasonably high circuit density, it involves the use of two different dielectric materials and the attendant complication of the necessary additional process steps.

IBM Technical Disclosure, Volume 21, No. 12, May 1979, page 4787, entitled "Tapered Vias in a Photosensitive Dielectric Film", teaches the formation of vias having sloping walls, for layers of circuitry deposited on a ceramic substrate. The method disclosed involves a photosensitive polyimide material (for providing the dielectric layer) which is exposed by means of a multi-density glass contact mask.

However, this method does not have sufficient resolution to produce vias suitable for 3 micron semiconductor fabrication processes.

It is an object of the present invention to remedy these drawbacks by providing a relatively simple and elegant method which enables the formation of accurate and reliable vias.

According to the invention there is provided, in the fabrication of a semiconductor wafer, a method of producing a via, the method being characterised by: the deposition of a layer of substantially non-erodable material over a layer of dielectric material; the formation of an aperture in the layer of substantially non-erodable material, for defining the via; the formation in a first portion of the layer of dielectric material defined by the aperture of a first passageway, having walls which are substantially perpendicular with respect to the wafer; and the formation in a second portion of the layer of dielectric material defined by the aperture of a second passageway, having walls which are inclined with respect to the walls of the first passageway, the first and second passageways being in communication such that they can accommodate a conductive material for providing an electrical connexion between first and second regions of the wafer at the distal ends of the first and second passageways respectively.

The formation of the second passageway could precede the formation of the first passageway, or vice versa.

The substantially non-erodable material preferably comprises an inorganic material.

The layer of dielectric material preferably comprises polyimide.

The invention will now be described by way of example with reference to the accompanying drawings, in which:

Figure 2 shows a cross-section of a portion of a semiconductor wafer at a process stage in a first method according to the invention;

Figure 3 shows a cross-section of a portion of a semiconductor wafer at a process stage in a second method according to the invention; and

Figure 4 shows a cross-section of the wafer portion shown in Figure 3 at a subsequent process stage.

Referring to Figure 2, an upper surface of a length of metal (in this case, aluminium) interconnect 3 is shown. This interconnect 3 is arranged over various circuit features (not shown) of the kind described with reference to Figure 1, and, as such, provides a conductive path at a first, lower level in the wafer to which connexions are to be made by vias to a subsequently - formed metal interconnect at a second, higher level in the wafer. A semiconductor wafer fabrication process involving such a structure is known as a "two-level metal" process.

A polyimide film 8 is formed over metal interconnect 3 in the usual way. A thin (500Å) layer 9 of inorganic material (in this case, titanium) is then deposited on the polyimide film 8. A via pattern is printed on this layer 9 by conventional photolithography and the layer 9 removed in the desired via location by wet or (preferably) dry etching to produce an opening 10. The layer 9 has a relatively high selectivity with respect to the film 8, and thus provides a substantially non-erodable material for defining the via in subsequent etching steps.

There follows a substantially anistropic etching step - by plasma etching - which not only removes a controlled depth of that part of the polyimide film 8 immediately below the opening 10, but also removes gradually diminishing parts of the polyimide film 8 in the underlying region surrounding the opening 10 such that an opening 11 is established therein which has sloping walls 12.

The next step in the process is a further etching step, but one which involves substantially anisotropic - rather than isotropic - etching. The via dimensions defined by the opening 10 in the inorganic layer 9 are thus reproduced to provide a further opening 13, having substantially perpendicular walls 14 and providing a via window, which opens onto the metal interconnect 3. This opening 13 has a height of approximately 0.5µm, thus providing the required dimensional control for the via and still permitting a portion (opening 11) of the via - with a depth of at least a further 0.5µm - to have sloping walls 12 for facilitating metal coating.

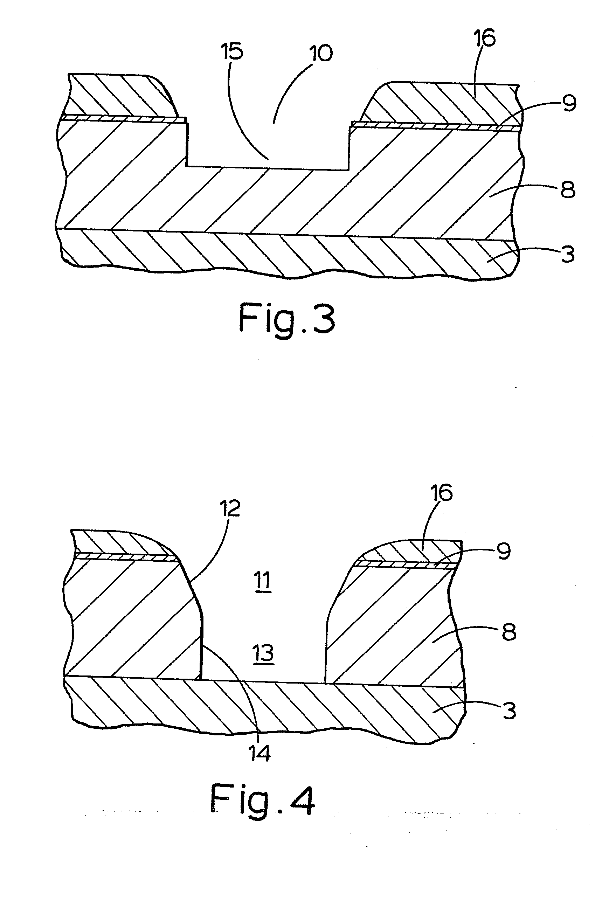

A second method of producing a via again involves the deposition of a polyimide film 8 over the metal interconnect 3 - as just described with reference to Figure 2. This is also followed by the deposition of a layer 9 of inorganic material (but in this case an aluminium layer having a thickness of 1000Å). Referring to Figure 3, the via pattern is printed by conventional photolithography and the layer 9 removed in the desired via location to provide the opening 10. However, the next step is one of substantially anisotropic etching which - with the opening 10 provided in the metal mask provided by layer 9 - results in an opening 15 in the polyimide film 8, having substantially perpendicular walls.

The next process step is one of wet etching (isotropic etching) which has the effect of undercutting a layer 16 of standard resist material, previously deposited over the layer 9 for defining the via, by a horizontal distance of approximately 1µm - as shown in Figure 4. The substantially anisotropic etching process is then continued such that the profile of the resist layer 16 is reproduced to provide a via opening (not shown) having an upper portion with sloping walls and a lower portion with substantially perpendicular walls.

In the two methods described, an opening for a via is produced which comprises a lower passageway (opening 13) in communication with the interconnect 3 and having substantially perpendicular walls 14 which are within the desired size limit for vias, and an upper passageway (opening 11) for communicating with a second layer of metal interconnect (not shown) and which has sloping walls 12 which can readily and reliably be coated with metal in a subsequent metallisation step. The via opening (opening 13) providing communication with the metal interconnect 3 is known as the via "window".

The via windows thus produced are sufficiently small (ie less than 3.5$\mu$ ) to enable the methods to be used in, for example, 3 micron CMOS fabrication processes.

The methods further resolve the well-known dilemma between providing an acceptable (and thus reliable) coverage of the via walls of the second metal layer and minimising the etch bias introduced by etching of a thick polyimide layer.

## CLAIMS

1. In the fabrication of a semiconductor wafer, a method of producing a via, the method being characterized by: the deposition of a layer (9) of substantially non-erodable material over a layer (8) of dielectric material; the formation of an aperture (10) in the layer (9) of substantially non-erodable material, for defining the via; the formation in a first portion of the layer (8) of dielectric material defined by the aperture (10) of a first passageway (13), having walls (14) which are substantially perpendicular with respect to the wafer; and the formation in a second portion of the layer (8) of dielectric material defined by the aperture of a second passageway (11), having walls (12) which are inclined with respect to the walls (14) of the first passageway (13), the first and second passageways being in communication such that they can accommodate a conductive material for providing an electrical connexion between first and second regions of the wafer at the distal ends of the first and second passageways respectively.

2. A method according to claim 1, wherein the formation of the second passageway (11) precedes the formation of the first passageway (13).

3. A method according to claim 1, wherein the formation of the first passageway (13) precedes the formation of the second passageway (11).

4. A method according to any preceding claim, wherein the first passageway (13) is formed by substantially anisotropic etching and the second passageway (11) is formed by substantially isotropic etching.

5. A method according to any preceding claim, wherein the said substantially non-erodable material comprises an inorganic material.

6.  A method according to any preceding claim, wherein the said dielectric material comprises polyimide.

7.  A semiconductor wafer provided with a via produced by a method according to any preceding claim.

8.  An integrated circuit made from a semiconductor wafer according to claim 7.

Fig.1

Fig.2

15   10                              16

                                          9

                                          8

                                          3

Fig.3

                          16

12                              9

_11_

_13_                            8

                                3

14

Fig.4

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 3) |
|---|---|---|---|
| Y | US-A-4 113 550 (HITACHI) <br><br> * Figures 7a-7d; column 11, lines 3-49 * <br><br> --- | 1,2,6, 7 | H 01 L 21/90 <br> H 01 L 23/52 |
| Y | EXTENDED ABSTRACTS, vol. 81-2, October 1981, pages 582-583, Pennington, New Jersey, USA; L.B. ROTHMAN: "Process for forming passivated metal interconnection system with a planar surface" <br> * Figure 1 * <br><br> --- | 1,2,5- 8 | |
| A | EXTENDED ABSTRACTS, vol. 80-1, May 1980, pages 289-290, Princeton, USA; L.B. ROTHMAN et al.: "Process for forming tapered vias in SiO2 by reactive ion etching" <br><br> --- | 1,2,5, 7 | **TECHNICAL FIELDS SEARCHED (Int. Cl. 3)** <br><br> H 01 L |
| A | IBM TECHNICAL DISCLOSURE BULLETIN, vol. 22, no. 10, March 1980, pages 4508-4509, New York, USA; R.K. AGNIHOTRI et al.: "Multilayer polyimide insulator for semiconductors" <br><br> ----- | 1,6 | |

The present search report has been drawn up for all claims

| Place of search <br> THE HAGUE | Date of completion of the search <br> 01-08-1984 | Examiner <br> DE RAEVE R.A.L. |
|---|---|---|

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82